# EUROPÄISCHE PATENTSCHRIFT

(11) **EP 0 772 889 B1**
(45) Veröffentlichungstag und Bekanntmachung des Hinweises auf die Patenterteilung: **16.12.1998**
(21) Anmeldenummer: 95924865.9
(22) Anmeldetag: 14.07.1995
(51) Int. Cl.: H01L 29/24, H01L 29/06, H01L 29/872, H01L 29/20, H01L 29/22, H01L 29/16, H01L 29/78

(54) **HALBLEITERBAUELEMENT MIT HOCHSPERRENDEM RANDABSCHLUSS**
SEMICONDUCTOR COMPONENT WITH A HIGH BLOCKING CAPABILITY EDGE TERMINATION
COMPOSANT A SEMI-CONDUCTEUR A TERMINAISON MARGINALE A HAUT POUVOIR DE BLOCAGE

(30) Priorität: 27.07.1994 DE 4426866
(43) Veröffentlichungstag der Anmeldung: 14.05.1997
(73) Patentinhaber: SIEMENS AKTIENGESELLSCHAFT, 80333 München (DE)
(72) Erfinder: MITLEHNER, Heinz, D-80798 München (DE); STEPHANI, Dietrich, D-91088 Bubenreuth (DE); WEINERT, Ulrich, D-91074 Hammerbach (DE)
(86) Internationale Anmeldenummer: DE9500935
(87) Internationale Veröffentlichungsnummer: WO9603774

(56) Entgegenhaltungen:
- EP-A- 0 159 544
- EP-A- 0 311 816
- EP-A- 0 380 340
- US-A- 5 233 215
- PATENT ABSTRACTS OF JAPAN Bd. 9, Nr. 99 (E-311) 27 April 1985 & JP,A,59 224 170 (MITSUBISHI DENKI K.K.) 17 Dezember 1984
- PATENT ABSTRACTS OF JAPAN Bd. 940, Nr. 011 & JP,A,06 314 791 (FUJI ELECTRIC CO LTD) 08 November 1994
- NEUES AUS DER TECHNIK, Nr. 6, Dezember 1981 WURZBURG DE, Seite 3 'PN-ÜBERGANG MIT SCHUTZRING'
- PATENT ABSTRACTS OF JAPAN Bd. 014, Nr. 032 (E-876) 22 Januar 1990 & JP,A,01 266 760 (SANKEN ELECTRIC CO LTD) 24 Oktober 1989

## Beschreibung

Die Erfindung betrifft ein Halbleiterbauelement.

Ein Halbleiterbauelement enthält im allgemeinen wenigstens einen aktiven Halbleiterbereich mit einem Halbleitergebiet eines Leitungstyps n oder p als Driftgebiet und zwei diesem Driftgebiet zugeordneten Elektroden zum Anlegen einer Betriebsspannung an das Driftgebiet sowie in der Regel weiteren Halbleitergebieten zum Ausbilden bauelementspezifischer Halbleiterstrukturen. In einem leitenden Zustand des Bauelements trägt das Driftgebiet den elektrischen Strom von Ladungsträgern zwischen den beiden Elektroden. Im Sperrzustand des Bauelements nimmt das Driftgebiet dagegen die Verarmungszone eines mit dem Driftgebiet gebildeten p-n-Übergangs oder sperrenden Metall-Halbleiter-Kontakts (Schottky-Kontakt) auf, die sich infolge der dann anliegenden, verglichen mit dem leitenden Zustand hohen Betriebsspannungen ausbildet. Die Verarmungszone wird oft auch als Raumladungszone oder Sperrschicht bezeichnet.

Man unterscheidet zwischen unipolar aktiven und bipolar aktiven Halbleiterbereichen. Bei unipolar aktiven Halbleiterbereichen ist nur eine Sorte von Ladungsträgern, Elektronen oder Löcher, funktionsbestimmend, während bei bipolar aktiven Halbleiterbereichen beide Ladungsträgertypen, also Elektronen und Löcher, zur Funktion beitragen.

Im Sperrzustand entstehen an der Oberfläche des Bauelements vergleichsweise hohe elektrische Felder. Man muß deshalb dafür sorgen, daß diese elektrischen Felder an der Oberfläche stabil in das das Bauelement umgebende Medium mit einer maximalen Feldstärke übergehen, die deutlich unterhalb der Durchschlagsfeldstärke des umgebende Mediums liegt. Das umgebende Medium können dabei dielektrische Schichten zur Isolation und/oder Passivierung oder auch ein umgebendes Gas, in der Regel Luft, sein. Das Problem zu hoher Feldstärken an der Oberfläche eines Bauelements tritt besonders bei hohen Sperrspannungen wie bei Anwendungen in der Leistungselektronik, kleinen Abmessungen mit hohen Feldlinienkrummungen oder hohen Dotierungen der Halbleitergebiete auf. Zur Verringerung der Feldstärken an der Oberfläche des Bauelements wird ein sogenannter Randabschluß eingesetzt, der in der Oberfläche des Bauelements erzeugt ist und den aktiven Bereich des Bauelements umgibt. Die Funktion eines Randabschlusses besteht neben der elektrischen Abschirmung des aktiven Halbleiterbereichs nach außen auch in einem Abbau der Feldlinienkrummungen um den aktiven Halbleiterbereich, um Feldüberhöhungen im oberflächennahen Bereich innerhalb des Halbleiterbauelements zu verringern.

Aus dem Buch "Modern Power Devices" von B.J.Baliga, 1987, Verlag John Wiley and Sons (USA), Seiten 79 bis 129 sind verschiedene Ausführungsformen von Randabschlüssen für p-n-Übergänge (junction termination) in Hochspannungsbauelementen auf Siliciumbasis bekannt. Solche p-n-Übergänge sind üblicherweise durch Diffusion eines Dotierstoffes in eine Oberfläche einer Siliciumschicht als Driftgebiet erzeugt, wobei das diffundierte Gebiet vom entgegengesetzten Leitungstyp ist wie die Siliciumschicht. An dem Rand des diffundierten Gebietes entsteht wegen der Feldlinienkrümnung in Abhängigkeit von der Tiefe dieses Gebietes eine Feldüberhöhung im Vergleich zum planaren p-n-Übergang.

Als Randabschluß können nun in einer ersten bekannten Ausführungsform sogenannte Feldringe (floating field rings) vorgesehen sein, die rings um das diffundierte Gebiet des p-n-Übergangs in der Siliciumschicht ebenfalls durch Diffusion erzeugt sind. Diese Feldringe sind vom gleichen Leitungstyp wie das diffundierte Gebiet des p-n-Übergangs und durch die entgegengesetzt dotierte Siliciumschicht jeweils voneinander getrennt. Es können einer oder mehrere Feldringe vorgesehen sein.

Eine zweite Möglichkeit, einen Randabschluß zu erhalten, besteht im Entfernen von Material und damit von Ladungen rings um den Rand des p-n-Übergangs durch mechanisches Abtragen oder Ätzen ("Beveled-edge termination" oder "Etch contour terminations"). Dadurch erhält man Mesastrukturen als Randabschlüsse.

Ein dritter bekannter Randabschluß für einen p-n-Übergang ist eine sogenannte Feldplatte (field plate). Dazu werden auf einen Randbereich um den p-n-Übergang eine Oxidschicht und darauf eine Metallschicht als Feldplatte aufgebracht. An die Metallschicht wird ein Feld angelegt , mit dem das Oberflächenpotential am Rand des p-n-Übergangs geändert wird. Dadurch kann ebenfalls die Verarmungszone des p-n-Übergangs und damit das Feld aufgeweitet werden. Die Feldplatte kann auch mit einer dem p-n-Übergang zum Anlegen einer Betriebsspannung zugeordneten Elektrodenschicht gebildet sein, die die Oxidschicht im Randbereich um den p-n-Übergang überlappt. Ein Randabschluß kann auch durch Kombination von Feldringen und Feldplatten gebildet sein ("Modern Power Devices", Seite 119).

Eine vierte bekannte Ausführungsform eines Randabschlusses beruht auf dem zum Entfernen von Ladungen komplementären Prozeß des kontrollierten Hinzufügens von entgegengesetzten Ladungen durch Ionenimplantation in die Oberfläche der als Driftgebiet vorgesehenen Siliciumschicht und wird als "junction termination extension" bezeichnet. Das implantierte Gebiet ist vom gleichen Leitungstyp wie das diffundierte Halbleitergebiet und damit entgegengesetzt dotiert zum Driftgebiet und weist eine niedrigere Dotierung auf als das diffundierte Gebiet. Anstelle eines mit dem in das Driftgebiet eindiffundierten Gebiets kann der p-n-Übergang auch mit einer auf der Oberfläche des Driftgebiets angeordneten entgegengesetzt zum Driftgebiet dotierten Siliciumschicht gebildet sein. Die Ionenimplantation des Randabschlusses erfolgt dann am Rand der beiden den p-n-Übergang bildenden Schichten. Der p-n-Übergang wird durch diesen Randabschluß praktisch erweitert, das elektrische Feld wird aufgeweitet und die Feldkrümmung verringert. Die Durchbruchsfestigkeit des Bauelements wird somit erhöht. Dieser "junction termination extension"-Randabschluß wird für bipolare Transistoren (BJT), Feldeffekttransistoren (MOSFETs) und Thyristoren (SCR = Silicon Controlled Rectifier) vorgeschlagen ("Modern Power Devices", Seite 128). Wegen der mit diesem Randabschluß geschaffenen zusätzlichen parasitären Diode entstehen insbesondere bei dem unipolaren, in Silicium gefertigten MOSFET erhebliche bipolare Leckströme im Sperrzustand des Bauelements durch Ladungsträgerinjektion. Diese Leckströme nehmen noch deutlich zu, wenn man den Randabschluß vergrößert, weil die Ladungsträgerinjektion mit der Fläche zunimmt.

Ein mit diesem "junction termination extension"-Randabschluß vergleichbarer, weiterer Randabschluß ist aus CH-A-659 542 bekannt und dort als Sperrschicht-Verlängerungsbereich bezeichnet. Dieser Randabschluß ist für einen p-n-Übergang als bipolar aktivem Halbleiterbereich eines Halbleiterbauelements vorgesehen und kann durch Ionenimplantation oder epitaktisches Aufwachsen erzeugt werden. Die laterale Ausdehnung (W_{JER}) des Sperrschicht-Verlängerungsbereiches wird größer als etwa die Hälfte der Verarmungsbreite (W_{id}) der gering dotierten Seite des p-n-Übergangs eingestellt. Bei Werten für die laterale Ausdehnung (W_{JER}) von über dem Doppelten der Verarmungsbreite (W_{id}) ergeben sich keine Verbesserungen mehr.

Siliciumcarbid (SiC) ist ein wegen seiner elektrischen und thermischen Eigenschaften besonders für die Hochtemperatur-und Leistungselektronik hervorragend geeignetes Halbleitermaterial. In Siliciumcarbid ist beispielsweise die maximal mögliche Feldstärke (Durchbruchs feldstärke) um einen Faktor von etwa 10 höher und die geometrischen Abmessungen sind entsprechend um einen Faktor von etwa 10 kleiner einstellbar als in Silicium.

Aus US 5 233 215 ist ein in Siliciumcarbid als Halbleiter gebildeter Leistungs-MOSFET bekannt mit Feldringen und Feldplatten als Randabschluß. Der aktive Bereich des MOSFET ist mit einer p-dotierten ersten Epitaxieschicht auf einem n⁻-dotierten Substrat und einer zweiten, n⁺-dotierten Epitaxieschicht gebildet. Der Randabschluß für den aktiven Bereich ist als durch Ätzen von durch die beiden Epitaxieschichten reichenden Gräben erzeugte Mesastruktur der beiden Epitaxieschichten ausgebildet. Mesastrukturen als Randabschluß reduzieren jedoch die von der Dotierung der Halbleitergebiete her mögliche Sperrspannung des Siliciumcarbid-Bauelements wegen der hohen elektrischen Felder nahe der Oberfläche des Bauelements. Dadurch wird die Verlustleistung im Bauelement erhöht.

Aus EP-A-0 380 340 ist eine Schottky-Diode aus SIC bekannt, die die Merkmale des Oberbegriffs des Anspruchs 1 aufweist.

Der Erfindung liegt nun die Aufgabe zugrunde, ein Halbleiterbauelement mit einem Randabschluß anzugeben. Durch den Randabschluß soll dabei der Leckstrom des Bauelements in dessen Sperrzustand nicht wesentlich erhöht werden.

Diese Aufgabe wird gemäß der Erfindung gelöst mit den Merkmalen des Anspruchs 1. Es ist wenigstens ein lateral in Richtung seiner Oberfläche bevorzugt ausgedehntes Halbleitergebiet eines ersten Leitungstyps vorgesehen. Dieses Halbleitergebiet nimmt in einem unipolar aktiven Bereich des Bauelements im Sperrzustand eine Verarmungszone mit einer von der Sperrspannung abhängigen vertikalen, d.h. im wesentlichen senkrecht zur Oberfläche des Halbleitergebiets verlaufenden, Ausdehnung auf und ist damit als Driftgebiet vorgesehen. Ein Randabschluß für den aktiven Bereich ist mit wenigstens einem weiteren Halbleitergebiet vom entgegengesetzten Leitungstyp wie das die Verarmungszone aufnehmende Driftgebiet gebildet und unmittelbar um den aktiven Bereich in oder an der Oberflache des Driftgebietes angeordnet.

Die laterale Ausdehnung des Randabschlusses ist größer als die maximale vertikale Ausdehnung der Verarmungszone, d.h. die maximale Verarmungszonentiefe, im Driftgebiet. Es wird somit gemäß der Erfindung in das Halbleiterbauelement ein vergleichsweise großflächiger, zwischen Randabschluß und Driftgebiet gebildeter p-n-Übergang eingebaut. Wegen der Ausräumung von Ladungsträgern aus der Raumladungszone dieses eingebauten p-n-Übergangs wird das elektrische Feld im Bereich der Oberfläche des Driftgebietes aufgeweitet und zugleich der aktive Bereich des Halbleiterbauelements gegen äußere Ladungen und Felder nahezu vollständig abgeschirmt. Ein Avalanchedurchbruch erfolgt entfernt von der Oberfläche des Halbleitergebiets sicher im Volumen. Ein besonderer Vorteil der größeren lateralen Ausdehnung des Randabschlusses gegenüber der vertikalen Ausdehnung der Verarmungszone besteht darin, daß die Durchbruchsspannung des Halbleiterbauelements deutlich unempfindlicher gegenüber Schwankungen in der Dotierung oder allgemein der Ladungsträgerkonzentration in dem Randabschluß ist.

Als Halbleiter für das Driftgebiet und den Randabschluß sind jeweils Halbleiter mit einem Bandabstand von wenigstens 2 eV vorgesehen. Dadurch werden Sperrströme im Sperrzustand des Halbleiterbauelements insbesondere auch bei höheren Temperaturen gering gehalten, weil die von Randabschluß und Driftgebiet gebildete parasitäre Diode auch bei hohen Sperrspannungen am aktiven Bereich und bei hohen Temperaturen nicht aufgesteuert wird und damit auch keine Minoritätsladungsträger in das Driftgebiet injiziert werden. Außerdem bleibt der Spannungsabfall über einem unipolar aktiven Bereich im Durchlaßbetrieb unter dem Spannungsabfall der parasitären Diode zwischen Randabschluß und Driftgebiet. Das unipolare Bauelement kann somit im wesentlichen speicherladungsfrei betrieben werden.

Man erhält somit durch die Kombination der Maßnahmen gemäß Anspruch 1 einen wirksamen Randabschluß zur elektrischen Abschirmung des aktiven Bereichs eines Halbleiterbauelements auch bei hohen Sperrspannungen.

Durch Einstellen der vertikalen Ausdehnung und/oder des Dotierprofils des Randabschlusses kann die Ausdehnung der Verarmungszone des mit Randabschluß und Driftgebiet gebildeten p-n-Übergangs und damit die Aufweitung des elektrischen Feldes an der Oberfläche weiter angepaßt werden, um die Durchbruchsfestigkeit und die Einstelltoleranz des Halbleiterbauelements noch weiter zu erhöhen.

Vorteilhafte Ausgestaltungen und Weiterbildungen des Halbleiterbauelements gemäß der Erfindung ergeben sich aus den vom Anspruch 1 abhängigen Ansprüchen.

Eine erste Ausführungsform des Halbleiterbauelements zeichnet sich demnach dadurch aus, daß die laterale Ausdehnung des Randabschlusses mindestens um den Faktor 5 größer ist als die maximale vertikale Ausdehnung der vom Halbleitergebiet aufgenommenen Raumladungszone.

In einer zweiten Ausführungsform umfaßt der Randabschluß wenigstens zwei Halbleiterbereiche unterschiedlicher Dotierung. Dadurch kann eine weichere, d.h. glattere, Aufweitung des elektrischen Feldes erreicht werden. Das Halbleiterbauelement ist mit einem derartigen, mehrstufig dotierten Randabschluß besonders robust gegenüber Herstelltoleranzen. Die wenigstens zwei Halbleiterbereiche können in vertikaler Richtung übereinander oder lateral nebeneinander angeordnet sein.

Bei einer weiteren Ausgestaltung des Halbleiterbauelement ist der Randabschluß epitaktisch auf der Oberfläche des als Driftgebiet vorgesehenen Halbleitergebiets aufgewachsen. Der Randabschluß kann aber auch durch Ionenimplantation erzeugt sein. Diese beiden Wege zur Herstellung des Randabschlusses erlauben eine genaue Einstellung des Dotierprofils, insbesondere der Höhe der Dotierung, und der Tiefe, d.h. vertikalen Ausdehnung, des Randabschlusses.

Der Randabschluß gemäß der Erfindung wird für ein Halbleiterbauelement mit einem unipolar aktiven Bereich, beispielsweise einer MISFET-Struktur oder einer Schottky-Dioden-Struktur eingesetzt.

In einer weiteren Ausführungsform kann ein dem aktiven Bereich des Halbleiterbauelements zugeordneter elektrischer Kontakt wenigstens teilweise auch den Randabschluß überlappen. Dadurch kann der Randabschluß auf ein definiertes Potential gelegt werden.

Vorzugsweise bestehen das Driftgebiet und der Randabschluß aus Siliciumcarbid (SiC). Damit erhält man ein für besonders hohe Sperrspannungen geeignetes Bauelement. Besonders vorteilhaft ist in dieser Ausführungsform die Dotierung des Randabschlusses mit Bor. Der Randabschluß ist dann besonders hochsperrend.

Zur weiteren Erläuterung der Erfindung wird auf die Zeichnung Bezug genommen, in deren
- FIG. 1: ein prinzipieller Aufbau eines Halbleiterbauelement mit einem Randabschluß,
- FIG. 2: ein Halbleiterbauelement mit einem Randabschluß für eine schottky-Dioden-struktur,
- FIG. 3: ein Halbleiterbauelement mit einem Randabschluß für eine p-n-Dioden-Struktur, das aber nicht Teil der Erfindung ist,
- FIG. 4: ein Halbleiterbauelement mit einem Randabschluß mit zwei unterschiedlich dotierten Halbleiterbereichen für eine MISFET-Struktur,
- FIG. 5: ein Diagramm der Durchbruchsspannung in Abhängigkeit von der Dotierung des Randabschlusses und
- FIG. 6: eine Feldverteilung bei einem Halbleiterbauelement mit einer Schottky-Dioden-Struktur
schematisch dargestellt sind. Einander entsprechende Teile sind mit denselben Bezugszeichen versehen.

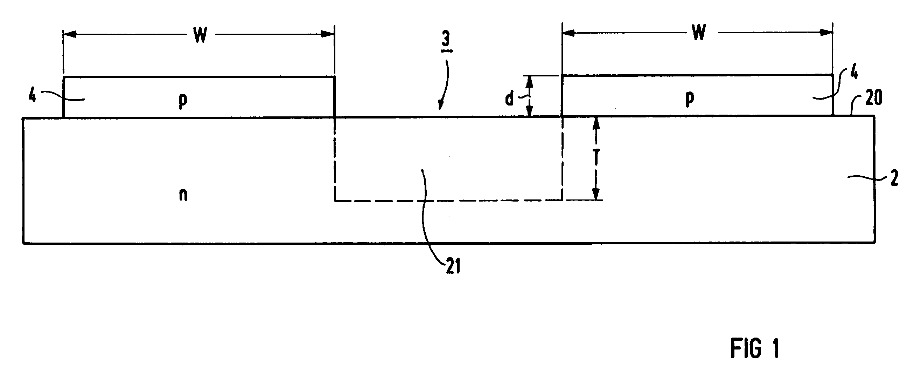

In FIG. 1 ist der prinzipielle Aufbau eines Halbleiterbauelements mit einem Randabschluß gemäß der Erfindung im Querschnitt gezeigt. Es sind ein Halbleitergebiet mit 2, ein elektronisch aktiver Bereich mit 3, der Randabschluß für diesen aktiven Bereich 3 mit 4, eine Oberfläche des Halbleitergebiets 2 mit 20 und eine in dem Halbleitergebiet 2 gebildete Verarmungszone (depletion zone) mit 21 bezeichnet.

Das Halbleitergebiet 2 bildet das Driftgebiet des Halbleiterbauelements und nimmt in dem aktiven Bereich 3 des Halbleiterbauelements in dessen sperrendem Zustand die Verarmungszone 21 des aktiven Bereichs 3 auf. Diese Verarmungszone 21 kann die Sperrschicht eines Schottky-Kontakts zwischen einem Metall und einem Halbleiter sein. Die vertikale, das heißt im wesentlichen senkrecht zur Oberfläche 20 des Halbleitergebietes 2 gerichtete, Ausdehnung der Verarmungszone 21 ist abhängig von einer im aktiven Bereich 3 über nicht dargestellte Elektroden angelegten Sperrspannung. Die einer vorgegebenen Sperrspannung entsprechende maximale vertikale Ausdehnung der Verarmungszone 21 ist mit T bezeichnet. Das Halbleitergebiet 2 ist in wenigstens einer lateralen, d.h. im wesentlichen parallel zu seiner Oberfläche 20 verlaufenden, Richtung stärker ausgedehnt als in vertikaler Richtung. Im allgemeinen ist das Halbleitergebiet 2 eine auf einem nicht dargestellten Substrat angeordnete, beispielsweise epitaktisch aufgewachsene Halbleiterschicht.

An der Oberfläche 20 des Halbleitergebiets 2 ist nun der Randabschluß 4 für den aktiven Bereich 3 des Halbleiterbauelements angeordnet. Der Randabschluß 4 schließt lateral unmittelbar an den aktiven Bereich 3 an und umgibt den gesamten aktiven Bereich 3. Die mit W bezeichnete laterale Ausdehnung des Randabschlusses 4 ist größer als die maximale vertikale Ausdehnung T der Verarmungszone 21 im Halbleitergebiet 2. Vorzugsweise ist die laterale Ausdehnung W des Randabschlusses 4 wenigstens fünfmal so groß wie die maximale vertikale Ausdehnung T der Verarmungszone 21. Bei einer Verarmungszonenausdehnung T von beispielsweise 10 µm ist die laterale Ausdehnung W des Randabschlusses 4 vorzugsweise zwischen 50 µm und 150 µm eingestellt. Die vertikale Ausdehnung d des Randabschlusses 4 ist vorzugsweise im wesentlichen konstant.

Ferner ist der Randabschluß 4 mit wenigstens einem Halbleiter vom entgegengesetzten Leitungstyp wie das Halbleitergebiet 2 gebildet. In der dargestellten Ausführungsform ist das Halbleitergebiet 2 n-leitend, und der Randabschluß 4 ist p-leitend. Bei einem p-leitenden Halbleitergebiet 2 ist hingegen ein n-leitender Randabschluß 4 vorzusehen. Vorzugsweise ist der Randabschluß 4 durch Ionenimplantation von Dotierstoffteilchen in die Oberfläche 20 des Halbleitergebiets 2 oder durch Aufwachsen einer entsprechend zu dotierenden Epitaxieschicht auf die Oberfläche 20 des Halbleitergebiets 2 erzeugt.

Das Halbleitergebiet 2 und der Randabschluß 4 sind jeweils mit wenigstens einem Halbleiter mit einem Bandabstand von mindestens 2 eV gebildet. Geeignete Halbleitermaterialien sind beispielsweise Bornitrid (BN), Borphosphid (BP), Aluminiumphosphid (AlP), Galliumphosphid (GaP), Zinksulfid (ZnS) oder Diamant (C). Besonders geeignet ist wegen seiner hervorragenden elektronischen Eigenschaften Siliciumcarbid (SiC) in allen seinen Polytypen, insbesondere jedoch der 6H-, der 4H-und der 3C-Polytyp.

Mit einem Randabschluß 4 gemäß FIG. 1 wird in das Halbleiterbauelement im Bereich der Oberfläche 20 des Halbleitergebiets 2 ein vergleichsweise großflächiger p-n-Übergang eingebaut. Die im sperrenden Zustand des Halbleiterbauelements sich aufbauende Raumladungszone dieses p-n-Übergangs schirmt zum einen den aktiven Bereich 3 und das Halbleitergebiet 2 gegen elektrische Felder und Ladungen von außerhalb des Bauelements ab und führt zum anderen zu einer Aufweitung des elektrischen Felds im Bereich der Oberfläche 20. Damit wird die Durchbruchsfestigkeit des Bauelements erhöht, und es können an den aktiven Bereich 3 höhere Sperrspannungen angelegt werden. Wegen des im Vergleich zu Silicium (Si) hohen Bandabstands des oder der verwendeten Halbleiter von mindestens 2 eV hat die mit dem Randabschluß 4 und dem Halbleitergebiet 2 gebildete großflächige p-n-Diode eine hohe Built-in-Spannung und wird auch bei hohen Sperrspannungen nicht aufgesteuert. Deshalb werden durch den Randabschluß 4 im wesentlichen keine zusätzlichen Sperrströme im Halbleiterbauelement erzeugt. Die erreichbaren Sperrspannungen sind deshalb deutlich höher als in Silicium. Die Built-in-Spannung eines in SiC gebildeten p-n-Übergangs ist beispielsweise größer als etwa 2,6 V.

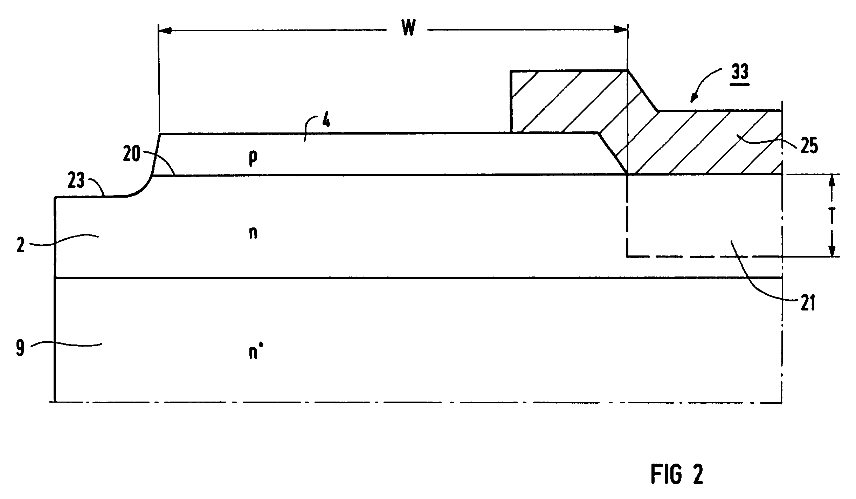

In FIG. 2 ist ein Teil einer Ausführungsform eines Halbleiterbauelements mit wenigstens einer Schottky-Dioden-Struktur 33 als unipolar aktivem Bereich im Querschnitt dargestellt. Auf einem Substrat 9 aus einem n-dotierten Halbleiter ist eine ebenfalls n-dotierte epitaktisch aufgewachsene Halbleiterschicht als Halbleitergebiet 2 angeordnet. Diese Epitaxieschicht ist im allgemeinen niedriger dotiert als das Substrat 9. Das Substrat 9 muß nicht aus einem Halbleiter mit einem hohen Bandabstand bestehen und kann beispielsweise auch mit Silicium gebildet sein, insbesondere dann, wenn das Halbleitergebiet 2 mit Siliciumcarbid gebildet ist. Die Schottky-Dioden-Struktur 33 enthält einen auf der Oberfläche 20 des Halbleitergebietes 2 angeordneten, im allgemeinen metallischen Kontakt 25 als Schottky-Kontakt. Die sich unterhalb des Kontakts 25 in dem Halbleitergebiet 2 bei Anlegen einer Sperrspannung ausbildende Sperrschicht der Schottky-Dioden-Struktur 33 bildet die Verarmungszone 21 im aktiven Bereich des Halbleiterbauelements. Unmittelbar anschließend an den Kontakt 25 ist auf dem Halbleitergebiet 2 eine epitaktisch aufgewachsene p-dotierte Halbleiterschicht als Randabschluß 4 angeordnet. Die den Randabschluß 4 bildende Halbleiterschicht ist in ihrer Schichtebene (laterale Ausdehnung W) deutlich stärker ausgedehnt als die Schichtdicke des Halbleitergebiets 2 und damit auch als die maximale vertikale Ausdehnung T der Verarmungszone 21. Der Randabschluß 4 kann sich bis zum Rand des Halbleitergebiets 2 erstrecken. Der Kontakt 25 ist vorzugsweise auch auf einem Teil des Randabschlusses 4 angeordnet (überlappender Kontakt). Außerdem können das Halbleitergebiet 2 und der Randabschluß 4 an ihren äußeren, vom aktiven Bereich abgewandten Rändern auch mit einer Aussparung 23 versehen sein, z.B. einem beveled-etch-Rand. Bei Verwendung von Siliciumcarbid als Halbleiter für die Schottky-Dioden-Struktur 33 und ihren Randabschluß 4 können an die dargestellte Schottky-Dioden-Struktur 33 beispielsweise bei einer Dotierung von n = 10¹⁶ cm⁻³ für das Halbleitergebiet 2 Sperrspannungen von bis zu 1200 V angelegt werden. Im Durchlaßbetrieb bleibt der Spannungsabfall zwischen dem Kontakt 25 und einer weiteren, nicht dargestellten Elektrode in der Schottky-Dioden-Struktur 33 unter dem Spannungsabfall der parasitären p-n-Diode zwischen Randabschluß 4 und Halbleitergebiet 2. Dadurch ist ein im wesentlichen speicherladungsfreier Betrieb des unipolaren Bauelements gewährleistet.

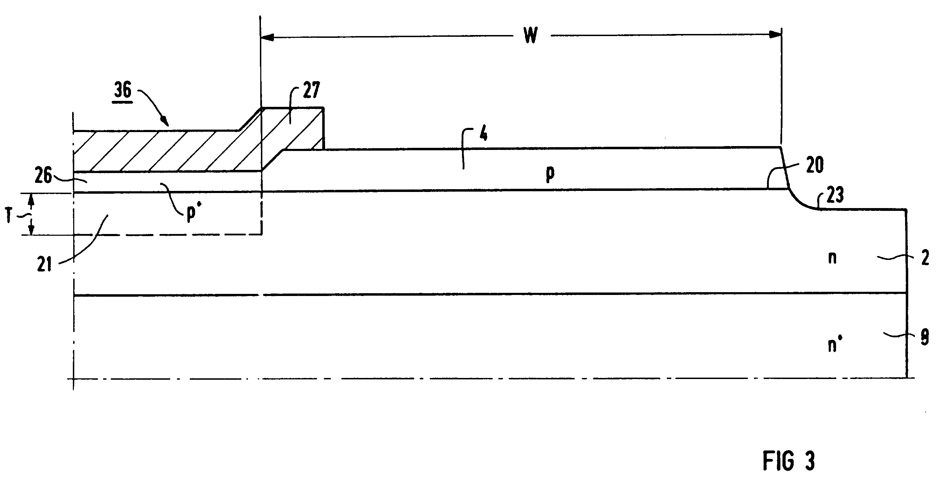

Ein Teil eines Halbleiterbauelements mit wenigstens einer p-n-Dioden-Struktur 36 als bipolar aktivem Bereich ist in FIG. 3 im Querschnitt gezeigt. Diese Struktur ist aber nicht Teil der vorliegenden Erfindung. Das Halbleitergebiet 2 ist epitaktisch auf einem Halbleitersubstrat 9 aufgewachsen und vom gleichen Leitungstyp (n-leitend) wie das Substrat 9. Der p-n-Übergang der p-n-Dioden-Struktur 36 ist mit dem n-leiten-den Halbleitergebiet 2 und einem auf der Oberfläche 20 des Halbleitergebiets 2 angeordneten, vorzugsweise epitaktisch aufgewachsenen p-leitenden Halbleitergebiet 26 gebildet. Auf diesem p-leitenden Halbleitergebiet 26 ist ein ohmscher Kontakt 27 angeordnet. Die Raumladungszone des p-n-Übergangs der p-n-Dioden-Struktur 36 bildet hier die Verarmungszone 21 des aktiven Bereichs. Als Randabschluß 4 für die p-n-Dioden-Struktur 36 ist eine vorzugsweise epitaktisch auf die Oberfläche 20 des Halbleitergebiets 2 aufgewachsene p-leitende Halbleiterschicht vorgesehen. Diese Halbleiterschicht des Randabschlusses 4 grenzt direkt an das p-leitende Halbleitergebiet 26 der p-n-Dioden-Struktur 36 an. Der ohmsche Kontakt 27 kann wieder den Randabschluß 4 teilweise überlappen. Außerdem kann auch wieder eine Aussparung 23 am Rand des Halbleitergebietes 2 vorgesehen sein. Anstelle epitaktisch aufgewachsener Halbleitergebiete können natürlich auch ionenimplantierte Halbleitergebiete vorgesehen sein.

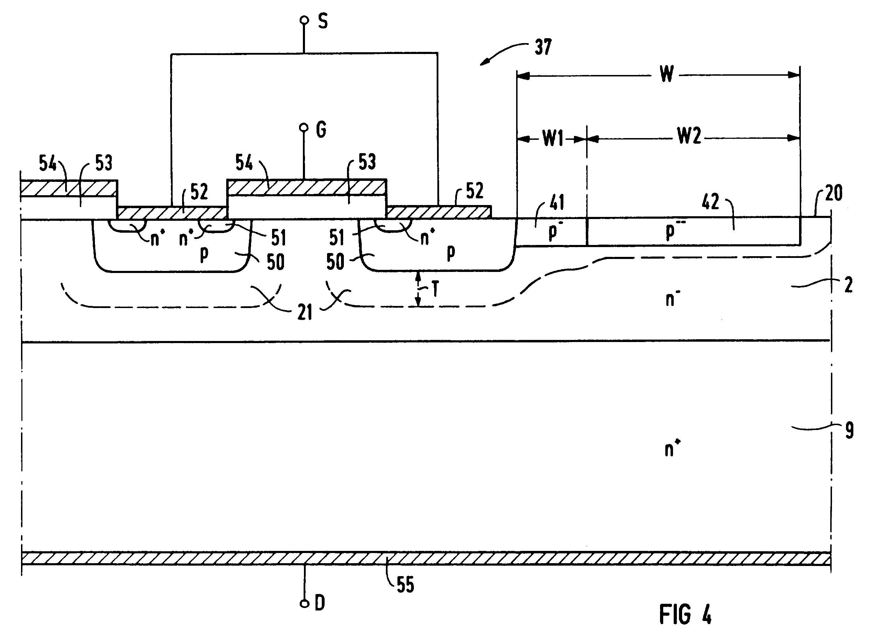

Die FIG. 4 veranschaulicht ein Halbleiterbauelement mit wenigstens einer MISFET-Struktur 37 als weiteres Ausführungsbeispiel eines Halbleiterbauelements mit einem unipolar aktiven Bereich. Das auf dem n⁺-dotierten Substrat 9 angeordnete n-dotierte Halbleitergebiet 2 stellt das Driftgebiet der MISFET-Struktur 37 dar. Die MISFET-Struktur 37 umfaßt wenigstens ein p-dotiertes, in der Oberfläche 20 des Halbleitergebiets 2 durch Ionenimplantation oder Diffusion erzeugtes Basisgebiet 50, wenigstens ein innerhalb des Basisgebietes 50 ebenfalls durch Ionenimplantation oder Diffusion erzeugtes Sourcegebiet 51, wenigstens eine Sourceelektrode 52 der Source S, über die das Sourcegebiet 51 und das Basisgebiet 50 elektrisch kurzgeschlossen sind, eine über eine Isolatorschicht 53 elektrisch isoliert über einem das Sourcegebiet 51 und das Halbleitergebiet 2 verbindenden Kanalgebiet des Basisgebiets 50 angeordnete Gateelektrode 54 des Gate G (insulated gate) und eine auf der vom Halbleitergebiet 2 abgewandten Seite des Substrats 9 angeordnete Drainelektrode 55 der Drain D. Die vom Halbleitergebiet 2 aufgenommene Verarmungszone 21 des zwischen Basisgebiet 50 und Halbleitergebiet 2 gebildeten p-n-Übergangs ist schematisch angedeutet. Die MISFET-Struktur 37 kann insbesondere, wie in der FIG. 4 dargestellt, aus einzelnen Zellen mit jeweils einem Basisgebiet 50 und wenigstens einem Sourcegebiet 51 mit zugeordneter Sourceelektrode 52 und die einzelnen Zellen überbrückenden isolierten Gateelektroden 54 aufgebaut sein. Solche Zellendesigns sind an sich in vielfältigen Ausführungen bekannt. Der Randabschluß 4 für die MISFET-Struktur 37 schließt unmittelbar an das am äußeren Rand der MISFET-Struktur 37 liegende Basisgebiet 50 an und ist ebenso wie das Basisgebiet 50 entgegengesetzt dotiert zum Halbleitergebiet 2. Vorzugsweise ist der Randabschluß 4 durch Ionenimplantation von Dotierstoffteilchen in die Oberfläche 20 des Halbleitergebietes erzeugt. Der Randabschluß 4 und/ oder das Basisgebiet 50 der MISFET-Struktur 37 können aber auch Epitaxieschichten sein.

In der in FIG. 4 dargestellten, vorteilhaften Ausführungsform ist der Randabschluß 4 aus wenigstens zwei unterschiedlich dotierten Halbleitergebieten 41 und 42 aufgebaut. Diese beiden Halbleitergebiete 41 und 42 sind lateral nebeneinander an der Oberfläche 20 des Halbleitergebiets 2 angeordnet und vorzugsweise entweder beide implantiert oder diffundiert oder beide epitaktisch aufgewachsen. Vorzugsweise weisen beide Halbleitergebiete 41 und 42 dabei etwa die gleiche vertikale Ausdehnung auf. Das der MISFET-Struktur 37 unmittelbar benachbarte Halbleitergebiet 41 ist niedriger dotiert (p⁻) als das angrenzende Basisgebiet 50 der MISFET-Struktur 37 und hoher dotiert als das auf der von diesem Basisgebiet 50 abgewandten Seite lateral anschließende, p⁻⁻-dotierte Halbleitergebiet 42. Man erhält so einen Randabschluß 4 mit einer abgestuften Dotierung. In einer vorteihaften Ausführungsform ist die laterale Ausdehnung W1 des ersten Halbleitergebiets 41 kleiner als die laterale Ausdehnung W2 des zweiten Halbleitergebiets 42 eingestellt. Die gesamte laterale Ausdehnung W des Randabschlusses 4 ergibt sich dabei als Summe der einzelnen Ausdehnungen W1 und W2 der beiden Halbleitergebiete 41 und 42. Diese gesamte laterale Ausdehnung W des Randabschlusses 4 ist nun wieder größer eingestellt als die maximale vertikale Ausdehnung T der Verarmungszone 21 der MISFET-Struktur 37.

Die beiden Halbleitergebiete 41 und 42 können auch in einer nicht dargestellten Ausführungsform vertikal übereinander angeordnet sein. Ein solcher vertikaler Aufbau kann beispielsweise durch Ionenimplantation oder Diffusion mit unterschiedlichen Eindringtiefen erzeugt werden oder indem man die Halbleitergebiete nacheinander epitaktisch übereinander aufwächst. Das unten angeordnete Halbleitergebiet ist dann vorzugsweise niedriger dotiert als das oben angeordnete Halbleitergebiet. Die laterale Ausdehnung W des Randabschlusses ist dann im wesentlichen durch die größte laterale Ausdehnung der einzelnen, vertikal übereinander angeordneten Halbleitergebiete bestimmt. Vorzugsweise sind die lateralen Ausdehnungen aller Halbleitergebiete wenigstens annähernd gleich groß.

Ferner kann der Randabschluß auch aus einer lateralen oder einer vertikalen Anordnung von mehr als zwei, jeweils unterschiedlich dotierten Halbleitergebieten bestehen, wobei die Dotierung vorzugsweise lateral nach außen bzw. vertikal nach unten abnimmt.

Solche mehrstufigen Randabschlüsse sind nicht auf Halbleiterbauelemente mit MISFET-Strukturen beschränkt, sondern können auch bei allen anderen Halbleiterbauelementen vorgesehen sein. Diese mehrstufig dotierten Randabschlüsse haben den Vorteil, daß das elektrische Feld im Bereich der Oberfläche 20 des Halbleitergebietes 2 einen weicheren Verlauf von dem aktiven Bereich nach außen annimmt.

Es versteht sich, daß in allen bisher beschriebenen Ausführungsbeispielen die Leitungstypen aller Halbleitergebiete jeweils vertauscht werden können.

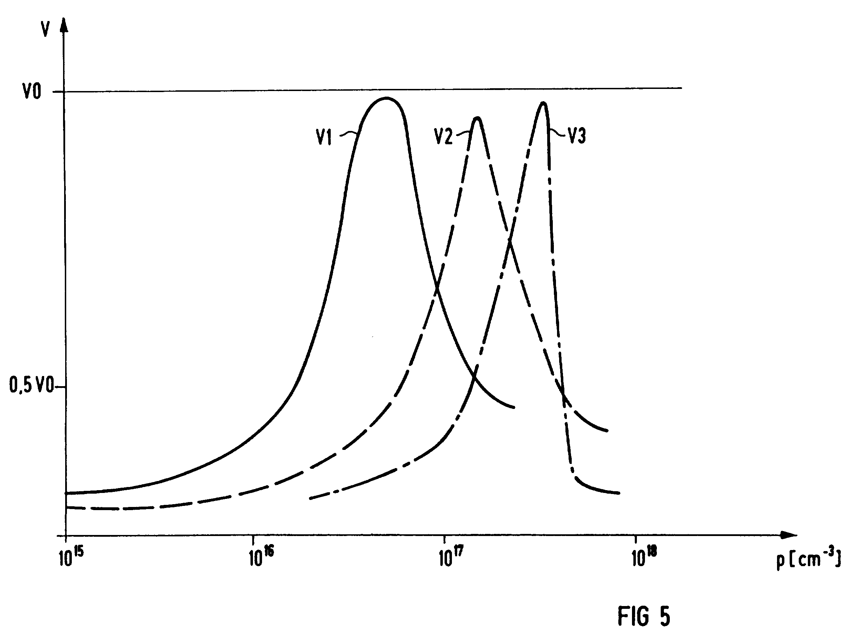

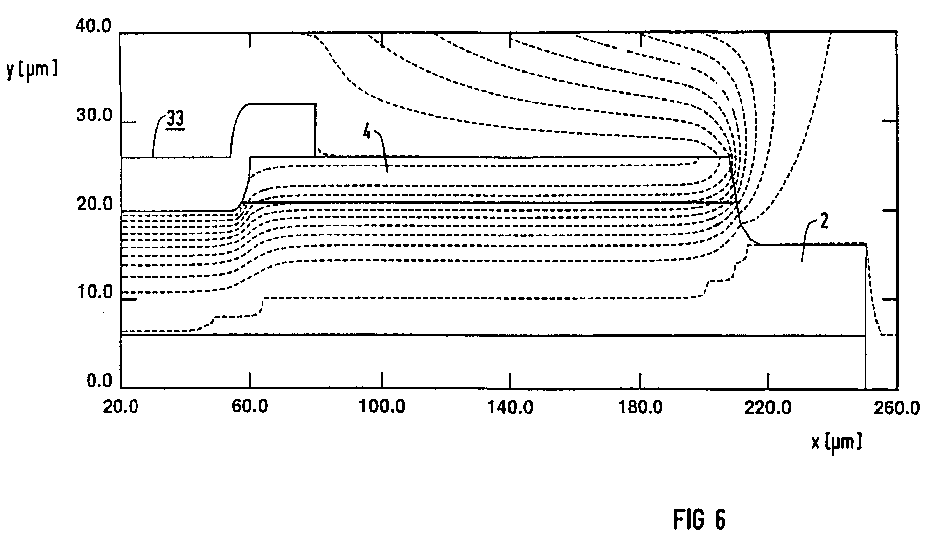

Die FIG. 5 und 6 zeigen Ergebnisse von numerischen, rechnergestützten Simulationen von Halbleiterbauelementen mit Randabschlüssen gemäß der Erfindung. Die Rechnungen basieren auf SiC als Halbleitermaterial für das Halbleiterbauelement.

In dem Diagramm der FIG. 5 ist die Durchbruchsspannung (Break-down voltage) V des Halbleiterbauelements als Funktion der logarithmisch aufgetragenen Dotierung p des (einstufigen) Randabschlusses 4 des Halbleiterbauelements in Abhängigkeit von drei verschiedenen vertikalen Ausdehnungen d des Randabschlusses 4 als Parameter aufgetragen für eine fest vorgegebene laterale Ausdehnung W des Randabschlusses 4. Die mit V1 bezeichnete, durchgezogene Kurve entspricht einer vertikalen Ausdehnung d = 2 µm, die gestrichelte Kurve V2 einer vertikalen Ausdehnung d = 0,7 µm und die strichpunktierte Kurve D3 einer vertikalen Ausdehnung d = 0,3 µm des Randabschlusses 4. Alle drei Kurven zeigen ausgeprägte Maxima in jeweils einem bestimmten Dotierungsbereich. Im Bereich dieser Maxima ist die Durchbruchsspannung V des Halbleiterbauelements praktisch gleich der idealen, theoretisch möglichen Durchbruchspannung V0 im Volumen des Halbleiterbauelements. Die Maxima sind bei kleinerer vertikaler Ausdehnung d des Randabschlusses 4 zu höheren Dotierungen hin verschoben und dabei zugleich breiter, wenn man die logarithmische Darstellung der Dotierung p beachtet. Durch Einstellen der vertikalen Ausdehnung d des Randabschlusses 4 kann somit das Halbleiterbauelement robuster gegenüber Herstellungstoleranzen bei der Dotierung des Randabschlusses 4 gemacht werden.

Der in FIG. 5 dargestellte qualitative Verlauf der Durchbruchsspannung V in Abhängigkeit von der Dotierung p (oder n) des Randabschlusses 4 ist weitgehend unabhängig von dem Aufbau des aktiven Bereichs und auch von der Dotierung des Halbleitergebiets 2 des Halbleiterbauelements und kann bei allen Ausführungsformen gemäß den FIG. 1 bis 4 festgestellt werden.

Die vertikale Ausdehnung d des Randabschlusses 4 beträgt typischerweise zwischen 0,1 µm und 5 µm.

FIG. 6 zeigt eine mit dem Randabschluß 4 gemäß der Erfindung mögliche Feldverteilung am Beispiel eines Halbleiterbauelements mit einer Schottky-Dioden-Struktur 33 gemäß FIG. 2. Die in x-Richtung und y-Richtung aufgetragenen Maßstäbe zeigen die Größenverhältnisse und Abmessungen. Die elektrischen Feldlinien sind gestrichelt eingezeichnet.

Bei Verwendung von Siliciumcarbid (SiC) als Halbleitermaterial wird der Randabschluß 4 vorzugsweise mit Bor (B) oder auch mit Aluminium (Al) p-dotiert oder mit Stickstoff (N) n-dotiert. Besonders vorteilhaft ist Bor (B) als Dotierstoff für den Randabschluß 4, weil die Boratome tiefe Akzeptorniveaus in SiC bilden. Der Randabschluß 4 kann in dieser Ausführungsform besonders hohe Sperrspannungen abfangen.

In allen Ausführungsformen können neben dem Randabschluß 4 noch zusätzliche Passivierungsschichten aus dielektrischen oder halbisolierenden Materialien vorgesehen sein. Bei einem Halbleiterbauelement auf SiC-Basis können die Passivierungsschichten insbesondere aus amorphem SiC, aus Silicium (Si) oder Kohlenstoff (C) bestehen.

## Patentansprüche

1. Halbleiterbauelement mit
a) einem Halbleitergebiet (2), das
a1) aus einem Halbleiter eines vorgegebenen Leitungstyps (n oder p) mit einem Bandabstand von wenigstens 2 eV besteht,
a2) in wenigstens einer lateralen Richtung stärker ausgedehnt ist als in einer vertikalen Richtung und
a3) in wenigstens einem unipolar aktiven Bereich (3) eine Verarmungszone (21) mit einer von einer an dem unipolar aktiven Bereich (3) angelegten Sperrspannung abhängigen vertikalen Ausdehnung aufnimmt
sowie mit
b) einem Randabschluß (4) für den unipolar aktiven Bereich (3), der mit einem weiteren Halbleitergebiet gebildet ist, das
b1) aus einem Halbleiter vom entgegengesetzten Leitungstyp (p bzw.n) wie das erstgenannte Halbleitergebiet (2) und mit einem Bandabstand von wenigstens 2 eV besteht und
b2) den unipolar aktiven Bereich (3) unmittelbar umschließend an oder in einer Oberfläche (20) des erstgenannten Halbleitergebiets (2) angeordnet ist,
dadurch gekennzeichnet, daß
c) die laterale Ausdehnung (W) des Randabschlusses (4) größer ist als die maximale vertikale Ausdehnung (T) der Verarmungszone (21).

2. Halbleiterbauelement nach Anspruch 1, bei dem die laterale Ausdehnung (W) des Randabschlusses (4) mindestens fünfmal so groß wie die maximale vertikale Ausdehnung (T) der vom Halbleitergebiet (2) aufgenommenen Verarmungszone (21) ist.

3. Halbleiterbauelement nach Anspruch 1 oder Anspruch 2, bei dem der Randabschluß (4) wenigstens zwei Halbleiterbereiche (40 und 41) unterschiedlicher Dotierung umfaßt.

4. Halbleiterbauelement nach Anspruch 3, bei dem die beiden Halbleiterbereiche (40, 41) lateral nebeneinander angeordnet sind.

5. Halbleiterbauelement nach Anspruch 3, bei dem die beiden Halbleiterbereiche in vertikaler Richtung übereinander angeordnet sind.

6. Halbleiterbauelement nach einem der vorhergehenden Ansprüche, bei dem der Randabschluß (4) epitaktisch auf der Oberfläche (20) des Halbleitergebiets (2) aufgewachsen ist.

7. Halbleiterbauelement nach einem der Ansprüche 1 bis 5, bei dem der Randabschluß (4) durch Ionenimplantation erzeugt ist.

8. Halbleiterbauelement nach einem der vorhergehenden Ansprüche, bei dem ein dem aktiven Berich (3) zugeordneter elektrischer Kontakt (25) wenigstens teilweise den Randabschluß (4) überlappt.

9. Halbleiterbauelement nach einem der vorhergehenden Ansprüche, bei dem als Halbleiter für das Halbleitergebiet (2) und den Randabschluß (4) Siliciumcarbid (SiC) vorgesehen ist.

10. Halbleiterbauelement nach Anspruch 9, bei dem der Randabschluß (4) mit Bor (B) dotiert ist.

## Claims

1. A semiconductor component comprising
a) a semiconductor region (2) which
a1) consists of a semiconductor of a given conductivity type (n or p) with a band gap of at least 2 eV,
a2) extends further in at least one lateral direction than in a vertical direction and
a3) in at least one unipolarly active region (3) accommodates a depletion zone (21) having a vertical dimension which is a function of a blocking voltage applied to the unipolarly active region (3),
and comprising
b) a junction termination (4) for the unipolarly active region (3) formed by a further semiconductor region which
b1) consists of a semiconductor of the opposite conductivity type (p or n) to the first mentioned semiconductor region (2) with a band gap of at least 2 eV and
b2) is arranged on or in a surface (20) of the first mentioned semiconductor region (2), directly surrounding the unipolarly active region (3),
characterised in that
c) the lateral dimension (W) of the junction termination (4) is greater than the maximum vertical dimension (T) of the depletion zone (21).

2. A semiconductor component according to Claim 1, wherein the lateral dimension (W) of the junction termination (4) is at least five times greater than the maximum vertical dimension (T) of the depletion zone (21) accommodated by the semiconductor region (2).

3. A semiconductor component according to Claim 1 or Claim 2, wherein the junction termination (4) comprises at least two semiconductor regions (40 and 41) with different doping.

4. A semiconductor component according to Claim 3, wherein the two semiconductor regions (40, 41) are arranged laterally beside one another.

5. A semiconductor component according to Claim 3, wherein the two semiconductor regions are arranged one above another in the vertical direction.

6. A semiconductor component according to one of the preceding claims, wherein the junction termination (4) is epitaxially grown on the surface (20) of the semiconductor region (2) .

7. A semiconductor component according to one of Claims 1 to 5, wherein the junction termination (4) is produced by ion implantation.

8. A semiconductor component according to one of the preceding claims, wherein an electric contact (25) assigned to the active region (3) at least partially overlaps the junction termination (4).

9. A semiconductor component according to one of the preceding claims, wherein silicon carbide (SiC) is provided as semiconductor for the semiconductor region (2) and the junction termination (4).

10. A semiconductor component according to Claim 9, wherein the junction termination (4) is doped with boron (B).

## Revendications

1. Composant à semiconducteurs, comportant
a) un champ (2) à semiconducteurs, qui
a1) est constitué d'un semiconducteur d'un type de conductivité prescrit (n ou p) ayant une bande interdite d'au moins 2 eV,
a2) s'étend plus fortement dans au moins une direction latérale que dans une direction verticale, et
a3) reçoit dans au moins une zone (3) active de manière monopolaire une zone (21) d'appauvrissement ayant une étendue verticale qui dépend d'une tension de blocage appliquée à la zone (3) active de manière monopolaire
ainsi que comportant
b) une terminaison (4) marginale pour la zone (3) active de manière monopolaire, qui est formé par un champ à semiconducteurs supplémentaire qui
b1) est constitué d'un semiconducteur du type de conductivité (p ou n) opposé à celui du champ (2) à semiconducteurs mentionné en premier et ayant une bande interdite d'au moins 2 eV et
b2) est disposé, en entourant directement la zone (3) active de manière monopolaire, sur ou dans la surface (20) du champ (2) à semiconducteurs mentionné en premier,
caractérisé en ce que
c) l'étendue (W) latérale de la terminaison (4) marginale est plus grande que l'étendue (T) verticale maximale de la zone (21) d'appauvrissement.

2. Composant à semiconducteurs suivant la revendication 1, dans lequel l'étendue (W) latérale de la terminaison (4) marginale est au moins cinq fois plus grande que l'étendue (T) verticale maximale de la zone (21) d'appauvrissement reçue par le champ (2) à semiconducteurs.

3. Composant à semiconducteurs suivant la revendication 1 ou 2, dans lequel la terminaison (4) marginale comprend au moins deux zones (40) et (41) à semiconducteurs de dopages différents.

4. Composant à semiconducteurs suivant la revendication 3, dans lequel les deux zones (40, 41) à semiconducteurs sont disposées latéralement côté à côte;

5. Composant à semiconducteurs suivant la revendication 3, dans lequel les deux zones à semiconducteurs sont superposées dans la direction verticale.

6. Composant à semiconducteurs suivant l'une des revendications précédentes, dans lequel on obtient la terminaison (4) marginale par croissance par épitaxie à la surface (20) du champ (2) à semiconducteurs.

7. Composant à semiconducteurs suivant l'une des revendications 1 à 5, dans lequel la terminaison (4) marginale est produite par implantation ionique.

8. Composant à semiconducteurs suivant l'une des revendications précédentes, dans lequel un contact (25) électrique, associé à la zone (3) active chevauche au moins partiellement la terminaison (4) marginale.

9. Composant à semiconducteurs suivant l'une des revendications précédentes, dans lequel il est prévu comme semiconducteur pour le champ (2) à semiconducteurs et la terminaison (4) marginale du carbure de silicium (SiC).

10. Composant à semiconducteurs suivant la revendication 9, dans lequel la terminaison (4) marginale est dopée par du bore (B).
